Europäisches Patentamt

European Patent Office

Office européen des brevets

(11) Publication number: **0 048 146**
**B1**

(12) **EUROPEAN PATENT SPECIFICATION**

(45) Date of publication of patent specification: **23.07.86**

(51) Int. Cl.⁴: **H 03 K 17/78, H 01 L 31/16**

(21) Application number: **81304179.5**

(22) Date of filing: **11.09.81**

(54) Solid state optically coupled electrical switch.

(30) Priority: **12.09.80 US 186419**

(43) Date of publication of application:
**24.03.82 Bulletin 82/12**

(45) Publication of the grant of the patent:
**23.07.86 Bulletin 86/30**

(84) Designated Contracting States:
**DE FR GB IT SE**

(56) References cited:
**WO-A-81/00493**
**DE-A-3 000 890**
**GB-A-2 017 297**
**US-A-3 480 783**
**US-A-3 976 877**
**US-A-4 124 860**
**US-A-4 179 619**

**ELECTRONIC DESIGN, Vol. 28, No. 7, 29 March 1980 Rochelle Park E.T. RODRIGUEZ "Fast DMOS Optocouplers Beat SSRs in Speed and Reed Relays in Performance" pages 60 to 63**

(73) Proprietor: **THETA-J-CORPORATION**
**108 West Cummings Park**
**Woburn Massachusetts 01801 (US)**

(72) Inventor: **Rodriguez, Edward T.**
**16 Sargent Road**
**Winchester Massachusetts 01890 (US)**

(74) Representative: **Jones, Ian et al**
**POLLAK MERCER & TENCH High Holborn House**
**52-54 High Holborn**
**London WC1V 6RY (GB)**

(56) References cited:
**DESIGN ENGINEERING, Vol. 52, No. 3, March 1981 Waseca V. COUGHLIN et al. "Solid State Relays Meet OEM Requirements" pages 61 to 64**

Courier Press, Leamington Spa, England.

## Description

This invention relates to a solid state optically coupled electrical switch. Depending on the application and power level, such switches can be characterised in solid state relays (SSR's) or analog switches.

Known from "Fast DMOS optocouplers beat SSRs in speed and reed relays in performance" (Edward T. Rodriquez) Electronic Design Vo. 28, No. 7, pages 60—63, is a solid state optically coupled electrical switch comprising a solid state light emitter arranged to emit light in response to an input signal applied thereto, optically transparent material arranged to couple the light to a solid state photovoltaic series diode array to thereby create a voltage, and a metal dioxide semiconductor field effect transistor (MOSFET) responsive to the application of the voltage between the gate and source thereof to change from a first impedance state to a second impedance state.

The invention is concerned with achieving very fast turn-on and turn-off times, in such a switch.

The invention accordingly provides a second photovoltaic series diode array, both the diode arrays being positioned to be simultaneously illuminated by the light emitter, and a second FET connected across the gate and source or drain of the MOSFET, the second diode array being connected across the gate and source of the second FET, whereby at least one of the turn-on and turn-off of the MOSFET is accelerated.

The second diode array and the second FET can be arranged to accelerate discharge of the capacitance between the gate and the source of the MOSFET during turn-off thereof and/or to accelerate charge of the capacitance between the gate and the source of the MOSFET during turn-on thereof.

The light emitter may consist of a liquid epitaxy gallium or gallium aluminum arsenide LED to provide greater brightness than a simple diffused LED. Each photovoltaic array may contain 16 diodes connected in series with connections at either end or at the midpoint of the series string. The diode arrays can be fabricated using dielectric isolation techniques. This eliminates parasitic light-generated voltages which could exist at various PN junctions if conventional isolation-diffusion integrated circuit processing were used.

Light is coupled from the LED to the sensor through a thin, clear film. Coupling is by refractive means, as described in U.S. Patent 4 296 331.

Each diode array, when activated by light, generates slightly more than 0.5 volts per diode, or slightly above 8 volts in total. The chip size can be chosen so as to deliver only several microamperes, though larger chips could, of course, deliver more current. However, relatively low current is adequate to drive the gate of the FET because of its high input impedance.

All the diodes of each of the diode arrays can be constructed on the same chip by dielectric isolation technology, and the chip can also contain a metallized island, electrically isolated from the array and from each FET, on which is placed the light emitter, the chip being coated with a thin, clear refractive film to effect the coupling between the emitter and diode arrays, whereby an optically isolated analog switch is created in a small space.

The diodes of the diode arrays can be located around the light-emitter so as to be equally illuminated thereby, and a series array of dielectrically isolated photovoltaic diodes can be fabricated in a wagon wheel spoke geometry and coated with a hemispherical clear film such that a light emitter located centrally of the photovoltaic array illuminates all diodes substantially equally.

The MOSFET can be such that its turn-on and turn-off speeds are limited by the time taken for the gate capacitance to charge from the photovoltaic diode voltage or discharge through the equivalent gate source impedance. This length of switching time has the positive effect of essentially limiting circuit turn-on rate of change of current with time (di/dt) and turn-off rate of change of voltage with time (dv/dt) and prevents the generation of switching-induced radio frquency interference (RFI) regardless of load power factor, an attribute not readily feasible with conventional FRI-reducing, zero-voltage or zero-current axis thyristor switching circuits.

The MOSFET can be a depletion-mode vertical conduction (DMOS) MOSFET, constituting an output FET of the switch, the source and drain electrodes thereof being connected to output terminal means of the switch and the source and gate electrodes being connected directly to the ends of the first diode array and the second FET can be a depletion mode bias FET with source, drain and gate electrodes, the source and drain electrodes of the bias FET being connected to the drain and gate electrodes of the output FET, and the source and gate electrodes of the bias FET being connected to ends of the second diode array.

The MOSFET can however be an enhancement-mode vertical conduction (DMOS) MOSFET, again constituting an output FET of the switch, with the source and drain electrodes thereof being connected to output terminal means of the switch and the source and gate electrodes being connected directly to the ends of the first diode array, and the second FET can be a depletion-mode junction FET (JFET) with source, drain and gate electrodes, the source and drain electrodes of the JFET being connected to the drain and gate electrodes of the DMOS and the gate and source electrodes of the JFET being connected to the ends of the second diode array, the JFET providing a maximum turn-off bias to the DMOS when the JFET is at a low impedance, such low impedance condition of the JFET occurring when the second diode array is not illuminated, the JFET providing a turn on bias to the DMOS when the JFET is at a high impedance, such high impedance occurring when the second diode array is illuminated.

In carrying the present invention into effect, FET technology is combined with optoelectronic means to achieve both superior switching characteristics and fabrication means compatible with low-cost mass production.

The invention is further described below, by way of example, with reference to the accompanying drawings, in which:

Fig. 1 is a circuit diagram of a known switch;

Fig. 2 is a side view of the switch of Fig. 1;

Fig. 3 is a sectional side view of a MOSFET included in the switch;

Fig. 4 is a graph relating ON resistance of the MOSFET with gate voltage;

Fig. 5 is a circuit diagram of a first switch embodying the invention;

Fig. 6 is a sectional side view of the switch of Fig. 5;

Fig. 7 is a circuit diagram of a second switch embodying the invention;

Figs. 8 and 9 are plan views of alternative photovoltaic diode arrays; and

Figs. 10 and 11 are an equivalent circuit diagram and a sectional side view of the array of Fig. 9.

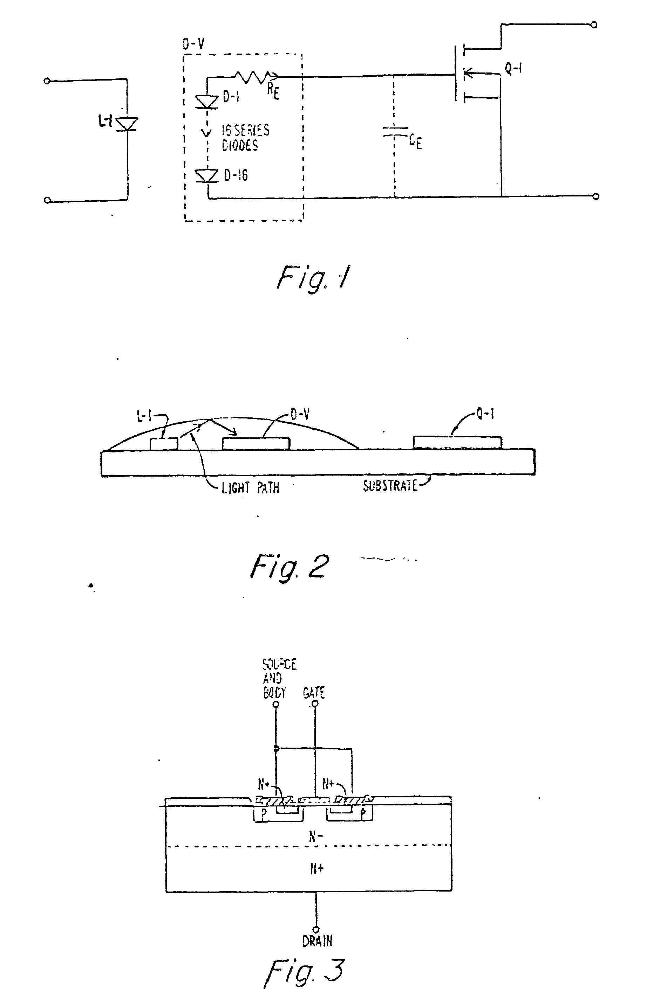

Fig. 1 shows a simple form of known switch in which an LED L-1 when activated by a control current of about 10 mA generates infrared radiation which is sensed simultaneously by all the diodes of an integrated diode array D—V comprising sixteen series connected diodes. Fig. 2 depicts the light path by which the radiation from the LED L-1 is refractively coupled with the diodes, by way of a thin clear film. The output of the array D—V is connected as shown to the gate and source of a MOSFET Q-1, the geometry of which is shown in cross-section in Fig. 3. MOSFET Q-1 exhibits an equivalent capacitance $C_E$ between its gate and source, which is of the order of several dozen picofarads for a chip 0.050 inches by 0.050 inches (1.27 mm. by 1.27 mm.).

When the array D—V is activated, the capacitance $C_E$ charges to the voltage generated through the D—V series equivalent resistance $R_E$ which, for a sensor chip of about 0.040 inches by 0.040 inches (1.01 mm. by 1.01 mm.), is about 1 Megohm.

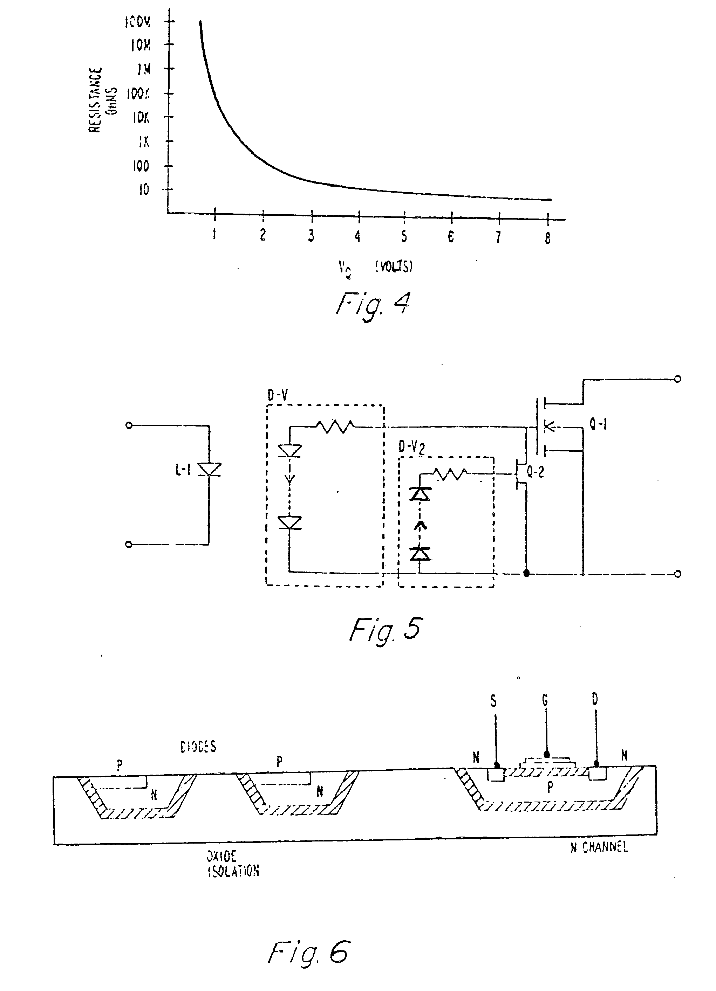

The turn-on time for the MOSFET Q-1 is the time it takes for the capacitance $C_E$ to charge to a high enough voltage for the MOSFET to have approached its lowest ON resistance. In this case, the two $R_E/C_E$ time constants put the MOSFET Q-1 gate voltage above 6 volts, a value where Q-1 is essentially full on. Fig. 4 depicts the effect of gate voltage $V_Q$ on ON resistance.

It may take, for example, about 20—50 microseconds to charge capacitance $C_E$ and turn on the MOSFET Q-1. When the signal to the LED L-1 is removed the diode array D—V stops generating a voltage. However, the charge remains on the capacitance $C_E$, thereby holding the MOSFET Q-1 on until stray leakage paths eventually discharge the capacitance C. Since several seconds could be required for discharge, alternate means for faster turn-off are normally required.

A preferred arrangement would be one in which the full D—V voltage is applied during turn-on with minimal biasing, but where maximum biasing is attained during turn-off. Such an arrangement is provided in the switch circuit in accordance with the invention illustrated in Fig. 5, in which are provided a P-channel depletion mode junction FET Q-2 and a second diode array D—$V_2$ receiving light from LED L-1 connected to the gate of FET Q-2. FET Q-2, being a depletion mode FET, is normally in a low impedance state, well under 1,000 ohms. When LED L-1 activates diode array D—$V_2$, Q-2 sees D—$V_2$ total voltage at its gate, causing FET Q-2 to be rapidly "pinched off" to a high impedance, thereby allowing enhanced turn-on time. When LED L-2 is deactivated, D—$V_2$ voltage collapses and FET Q-2 is no longer pinched off and drops to a low impedance, thereby causing a rapid $C_E$ discharge and turn-off of MOSFET Q-1.

The photovoltaic diode generators or arrays D—V and D—$V_2$ and the FET Q-2 are fabricated on the same chip using dielectric isolation. Each diode is electrically isolated from the next except for surface interconnect metallurgy, which proceeds from one anode to the next cathode. The oxide "tub" surrounding each diode prevents electrical interaction except between the P and N regions of each diode through surface interconnect metalization.

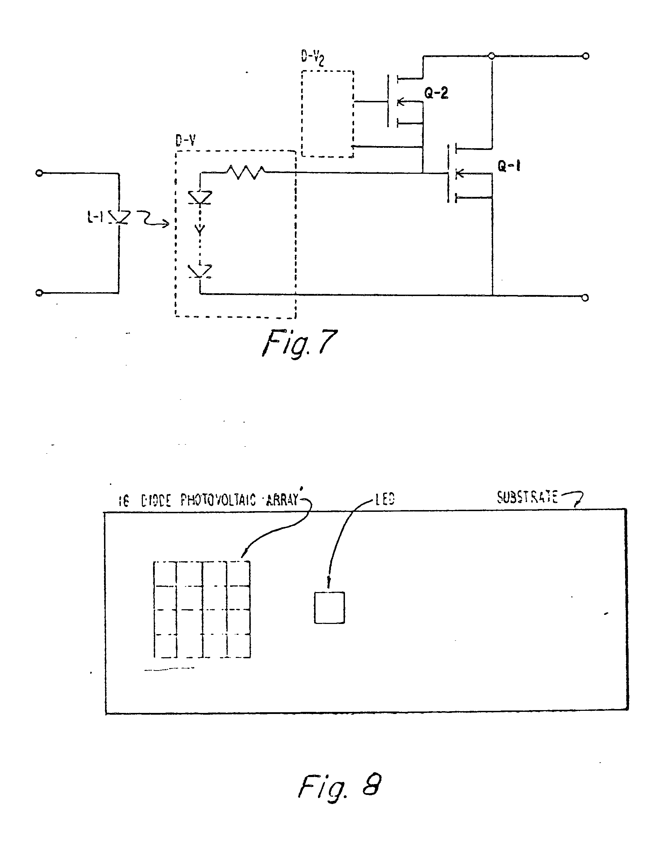

Such an array produced by conventional integrated circuit diffusion isolation technology would result in undesirable photovoltaic action at each isolation junction, cancelling out the desired effects. The dielectric process provides near perfect isolation and eliminates the many external-wire connections associated with individual diode chips. It also provides the maximum diode element location concentration for receiving light from LED L-1. Fig. 6 depicts the cross-sectional geometry of the diodes and the bias FET Q-2.

It has been noted that the use of a depletion mode FET such as FET Q-2 of Fig. 5 can enhance turn-off. It can also be noted that the addition of a photovoltaically activated FET Q-2 as in Fig. 7, can enhance turn-on speed as follows:

LED L-1 is so arranged as to simultaneously activate diode arrays D—V and D—$V_2$. The consequential reduced impedance of FET Q-2 causes FET Q-1 gate capacitance to suddenly begin charging toward the Hocking voltage through FET Q-2. FET Q-2 has an input capacitance much smaller than that of Q-1 by an order of magnitude equal to the degree of turn-on speed enhancement. Since Q-2 handles negligible current, it can be a much smaller chip than Q-1, thereby facilitating a geometry contributing less capacitance.

The result is the rapid charge of·the Q-1 gate capacitance and faster turn-on, which could not occur where gate capacitance to charge directly through the high impedance D—V voltage source.

With the means for turn-on just described, and the means of Fig. 5 for turn-off, it is possible to fabricate a bidirectional, distortion-free AC power amplifier or switch capable of operating at fre-

5 **0 048 146** 6

quencies above 1 Megahertz. Unlike a thyristor, the switch exhibits no regenerative mechanism and hence, cannot be latched on by a voltage transient.

With vertical DMOS technology, it is possible to integrate all elements, except for the LED, on a single chip using dielectric isolation technology. The single chip would include the photovoltaic diodes.

While the primary mode of fabrication is based on thick film hybrid circuit technology, variations of the preceding circuits can be readily fabricated totally on a single integrated circuit chip, with the exception of the LED's, in particular, by means of dielectric isolation technology. An integrated circuit (IC) employing the LED's, as well, is compatible with present knowledge of processing techniques, but is not yet economically feasible. Such a chip for example could be produced having all elements fabricated with Gallum Arsenide rather than having the diode and FET's processed with silicon as is currently the practice.

A major consideration in activating the photovoltaic array is that the maximum output current can be no greater than the current generated by the least illuminated diode in the series array. In a straight-forward matrix of series-connected diodes, such as depicted in Fig. 8, the diode farthest from the LED becomes a limiting factor. For comparable diode efficiency (comparable diode impedance in the illuminated state), the diode area should be larger as its distance from the LED increases.

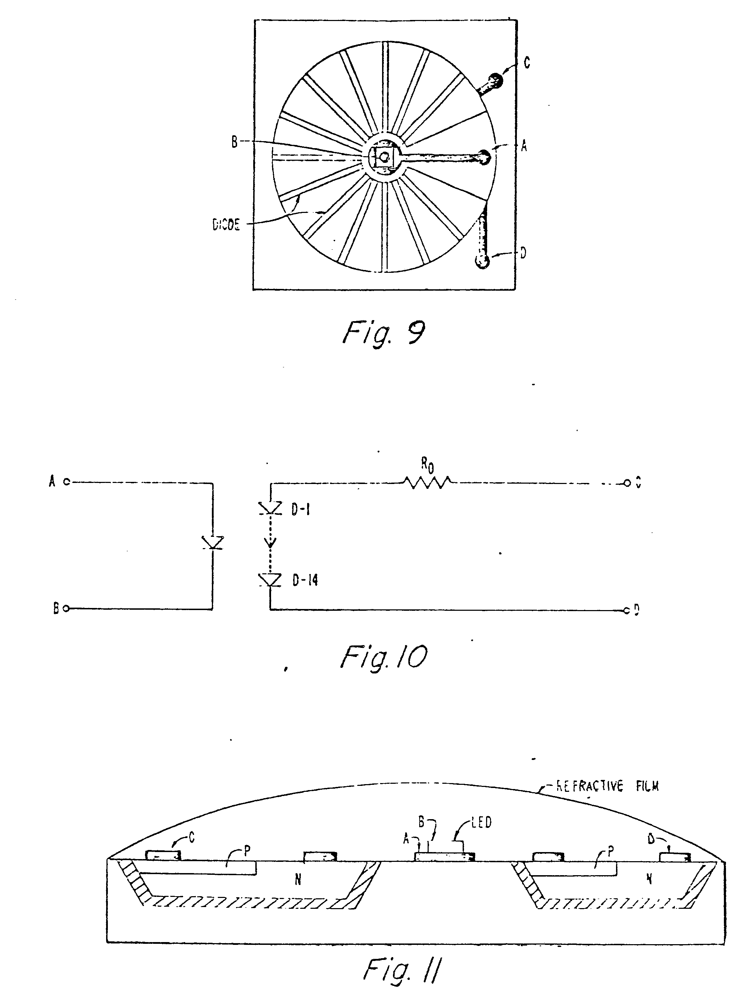

The optimized configuration, then, for a series string of photovoltaic diodes is the "wagon wheel" configuration shown in Fig. 9, with the LED mounted centrally so as to illuminate all the diodes equally. Fig. 10 shows the circuit of the configuration of Fig. 9, Ro being the series equivalent resistance of the array. The wagon wheel surface geometry, coupled with the hemispherical refractive film, shown in Fig. 11, provides maximum response to the LED hemispherical radiation pattern across the entire surface of each diode.

**Claims**

1. A solid state optically coupled electrical switch comprising a solid state light emitter (L-1) arranged to emit light in response to an input signal applied thereto, optically transparent material arranged to couple the light to a solid state photovoltaic series diode array (D—V) to thereby create a voltage, and a metal oxide semiconductor field effect transistor (MOSFET) (Q-1) responsive to the application of the voltage between the gate and source thereof to change from a first impedance state to a second impedance state, characterised by a second photovoltaic series diode array (D—V₂), both the diode arrays being positioned to be simultaneously illuminated by the light emitter (L-1), and by a second FET (Q-2) connected across the gate and source or drain of the MOSFET (Q-1), the second

diode array (D—V₂) being connected across the gate and source of the second FET (Q-2), whereby at least one of the turn-on and turn-off of the MOSFET (Q-1) is accelerated.

2. A switch as claimed in claim 1 wherein the second diode array and the second FET (Q-2) are arranged to accelerate discharge of the capacitance (Cₑ) between the gate and the source of the MOSFET (Q-1) during turn-off thereof.

3. A switch as claimed in claim 1 or 2 wherein the second diode array and the second FET (Q-2) are arranged to accelerate charge of the capacitance (Cₑ) between the gate and the source of the MOSFET (Q-1) during turn-on thereof.

4. A switch as claimed in claim 1, 2 or 3 wherein the MOSFET (Q-1) is a depletion-mode vertical conduction (DMOS) MOSFET, constituting an output FET of the switch, the source and drain electrodes thereof being connected to output terminal means of the switch and the source and gate electrodes being connected directly to the ends of the first diode array (D—V) and wherein the second FET (Q-2) is a depletion mode bias FET with source, drain and gate electrodes, the source and drain electrodes of the bias FET being connected to the drain and gate electrodes of the output FET, and the source and gate electrodes of the bias FET being connected to ends of the second diode array (D—V₂).

5. A switch as claimed in claim 1, 2 or 3 wherein the first-mentioned MOSFET (Q-1) is an enhancement-mode vertical conduction (DMOS) MOSFET, constituting an output FET of the switch, the source and drain electrodes thereof being connected to output terminal means of the switch and the source and gate electrodes being connected directly to the ends of the first diode array (D—V), and wherein the second FET (Q-2) is a depletion-mode junction FET (JFET) with source, drain and gate electrodes, the source and drain electrodes of the JFET being connected to the ends of the second diode array (D—V₂), the JFET providing a maximum turn-off bias to the DMOS when the JFET is at a low impedance, such low impedance condition of the JFET occurring when the second diode array is not illuminated, the JFET providing a turn on bias to the DMOS when the JFET is at a high impedance, such high impedance occurring when the second diode array is illuminated.

6. A switch as claimed in any preceding claim wherein the diode arrays (D—V, D—V₂) and the light emitter (L-1) are arranged in the same plane, and wherein a thin film overlies the diode arrays and the light emitter and provides an optical coupling path therebetween.

7. A switch as claimed in any one of claims 1—5 wherein all of the diodes of each of the diode arrays (D—V, D—V₂) are constructed on the same chip by dielectric isolation technology, the chip also containing a metallized island, electrically isolated from the array and from each FET, on which is placed the light emitter (L-1), and the chip being coated with a thin, clear refractive film to effect the coupling between the emitter and

4

diode arrays, whereby an optically isolated analog switch is created in a small space.

8. A switch as claimed in claim 6 or 7 wherein all the elements thereof are fabricated of Gallium Arsenide on a single monolithic chip employing dielectric isolation.

9. A switch as claimed in any preceding claim wherein the diodes of the diode arrays (D—V, D—V₂) are located around the light emitter (L-1) so as to be equally illuminated thereby.

## Patentansprüche

1. Optisch gekoppelter elektrischer Halbleiterschalter, bestehend aus einem Halbleiter-Lichtemitter (L-1), der in Abhängigkeit von einem angelegten Eingangssignal Licht emittiert, einem optisch transparenten Material, das das Licht zu einer Halbleiter-Photovoltaic-Seriendioden-array (D—V) überträgt, um eine Spannung zu erzeugen, und einem Metalloxid-Halbleiter-FET (MOSFET Q-1), der auf das Anlegen von Spannung zwischen dessen GATE- und SOURCE-Elektrode anspricht, um von einem ersten in einen zweiten Impedanzzustand überzugehen, gekennzeichnet durch eine zweite Voltaic-Seriendiodenarray (D—V₂), wobei beide Diodenarrays so angeordnet sind, daß sie von dem Lichtemitter (L-1) gleichzeitig beleuchtet werden, und durch einen zweite FET (Q-2), der über die GATE- und SOURCE- oder DRAIN-Elektroden des MOSFET (Q-1) geschaltet ist, wobei die zweite Diodenarray (D—V₂) über die GATE- und SOURCE-Elektroden des zweiten FET (Q-2) geschaltet ist, so daß wenigstens das Ein- oder Ausschalten des MOSFETS (Q-1) beschleunigt wird.

2. Schalter nach Anspruch 1, dadurch gekennzeichnet, daß die zweite Diodenarray und der zweite FET (Q-2) so angeordnet sind, daß sie die Entladung der Kapazität (C$_E$) zwischen der GATE- und der SOURCE-Elektrode des MOSFET (Q-1) während dessen Ausschalten beschleunigen.

3. Schalter nach Anspruch 1 oder 2, dadurch gekennzeichnet, daß die zweite Diodenarray und der zweite FET (Q-2) so angeordnet sind, daß sie die Ladung der Kapazität (C$_E$) zwischen der GATE- und der SOURCE-Elektrode des MOSFET (Q-1) während dessen Einschalten beschleunigen.

4. Schalter nach Anspruch 1, 2 oder 3, dadurch gekennzeichnet, daß der MOSFET (Q-1) ein Verarmungs-MOSFET (DMOS) mit vertikaler Leitung ist, der einen Ausgangs-FET des Schalters bildet, dessen SOURCE- und DRAIN-Elektroden mit einer Ausgangsanschlußeinrichtung des Schalters verbunden sind und dessen SOURCE- und GATE-Elektroden direkt mit den Enden der ersten Diodenarray (D—V) verbunden sind, und daß der zweite FET (Q-2) ein Verarmungs-Vorspannungs-FET mit SOURCE-, DRAIN- und GATE-Elektroden ist, dessen SOURCE- und DRAIN-Elektroden mit den DRAIN- und GATE-Elektroden des Ausgangs-FET und dessen SOURCE- and GATE-Elektroden mit den Enden der zweiten Diodenarray (D—V₂) verbunden sind.

5. Schalter nach Anspruch 1, 2 oder 3, dadurch gekennzeichnet, daß der erstgenannte MOSFET (Q-1) ein Anreicherungs-MOSFET (DMOS) mit vertikaler Leitung ist, der einen Ausgangs-FET des Schalters bildet, dessen SOURCE- und DRAIN-Elektroden mit der Ausgangsanschlußeinrichtung des Schalters verbunden sind und dessen SOURCE- und GATE-Elektroden direkt mit den Enden der ersten Diodenarray (D—V) verbunden sind, und daß der zweite FET (Q-2) ein Verarmungs-Sperrschicht-FET (JFET) mit SOURCE-, DRAIN- und GATE-Elektroden ist, dessen SOURCE- und DRAIN-Elektroden mit den Enden der zweiten Diodenarray (D—V₂) verbunden sind und der dem DMOS eine maximale Abschalt-Vorspannung zuführt, wenn der JFET auf niedriger Impedanz ist, wobei dieser Niedrigimpedanzzustand auftritt, wenn die zweite Diodenarray nicht beleuchtet ist, und wobei der JFET dem DMOS eine Einschaltvorspannung zuführt, wenn der JFET auf hoher Impedanz ist, wobei dieser hohe Impedanzzustand auftritt, wenn die zweite Diodenarray beleuchtet ist.

6. Schalter nach einem der Ansprüche 1 bis 5, dadurch gekennzeichnet, daß die Diodenarrays (D—V, D—V₂) und der Lichtemitter (L-1) in der gleichen Ebene angeordnet sind, und daß ein dünner Film über den Diodenarrays und dem Lichtemitter liegt, der einen optischen Kopplungsweg dazwischen schafft.

7. Schalter nach einem der Ansprüche 1 bis 5, dadurch gekennzeichnet, daß alle Dioden jeder der Diodenarrays (D—V, D—V₂) durch dielektrische Isolationstechnik auf dem gleichen Chip gebildet sind, wobei der Chip auch einen metallisierten Inselbereich aufweist, der von den Arrays und von jedem FET elektrisch isoliert ist, auf dem der Lichtemitter (L-1) angeordnet ist, und der mit einem dünnen, hellen Brechungsfilm überzogen ist, um die Kopplung zwischen dem Emitter und den Diodenarrays zu bewirken, so daß in einem kleinen Raum ein optisch isolierter Analogschalter geschaffen wird.

8. Schalter nach Anspruch 6 oder 7, dadurch gekennzeichnet, daß alle Elemente aus Galiumarsenid auf einem einzigen monolytischen Chip unter Anwendung von dielektrischer Isolation gebildet sind.

9. Schalter nach einem der Ansprüche 1 bis 8, dadurch gekennzeichnet, daß die Dioden den Diodenarrays (D—V, D—V₂) um den Lichtemitter (L-1) angeordnet sind, so daß sie von diesem gleich beleuchtet werden.

## Revendications

1. Commutateur électrique à semi-conducteurs à couplage optique, comprenant un émetteur de lumière à semi-conducteurs (L-1) prévu pour émettre de la lumière en réponse à l'application d'un signal d'entrée, une matière optiquement transparente disposée pour transmettre la lumière à un réseau (D—V) de diodes photovoltaïques en série à l'état solide de manière à créer une tension, et un transistor (MOSFET) à semi-conducteur métal-oxyde à effet de champ (Q-1) qui répond à l'application de la tension entre sa grille et sa source de sorte qu'il passe d'un premier état d'impédance à un deuxième état d'impédance, caractérisé en ce qu'il comprend un deuxième réseau (D—V₂) de diodes photovoltaïques en série, les deux réseaux de diodes étant placés de manière à être simultanément éclairés par l'émetteur de lumière (L-1), et un deuxième FET (Q-2) raccordé entre la grille et la source ou le drain du MOSFET (Q-1), le deuxième réseau de diodes (D—V₂) étant raccordé entre la grille et la source du deuxième FET (Q-2), de sorte qu'au moins l'un des passages à l'état conducteur ou à l'état non conducteur du MOSFET (Q-1) est accéléré.

2. Commutateur suivant la revendication 1, dans lequel le deuxième réseau de diodes et le deuxième FET (Q-2) sont prévus pour accélérer la décharge de la capacité (C$_E$) entre la grille et la source du MOSFET (Q₁) pendant son passage à l'état non conducteur.

3. Commutateur suivant la revendication 1 ou 2, dans lequel le deuxième réseau de diodes et le deuxième FET (Q-2) sont prévus pour accélérer la charge de la capacité (C$_E$) entre la grille et la source du MOSFET (Q-1) pendant son passage à l'état conducteur.

4. Commutateur suivant la revendication 1, 2 ou 3, dans lequel le MOSFET (Q-1) est un MOSFET (DMOS) à conduction verticale à appauvrissement, constituant un FET de sortie du commutateur, ses électrodes de source et de drain étant connectées aux bornes de sortie du commutateur et les électrodes de source et de grille étant connectées directement aux extrémités du premier réseau de diodes (D—V), et dans lequel le deuxième FET (Q-2) est un FET de polarisation à appauvrissement comportant des électrodes de source, de drain et de grille, les électrodes de source et de grain du FET de polarisation étant connectées aux électrodes de drain et de grille du FET de sortie, et les électrodes de source et de grille du FET de polarisation étant connectées aux extrémités du deuxième réseau de diodes (D—V₂).

5. Commutateur suivant la revendication 1, 2 ou 3, dans lequel le MOSFET (Q-1) cité en premier est un MOSFET (DMOS) à conduction verticale à enrichissement, constituant un FET de sortie du commutateur, ses électrodes de source et de drain étant connectées aux bornes de sortie du commutateur et les électrodes de source et de grille étant connectées directement aux extrémités du premier réseau de diodes (D—V), et dans lequel le deuxième FET (Q-2) est un FET à jonction (JFET) à appauvrissement comportant des électrodes de source, de drain et de grille, les électrodes de source et de drain du JFET étant connectées aux extrémités du deuxième réseau de diodes (D—V₂), le JFET fournissant une polarisation maximale de coupure au DMOS lorsque le JFET est à une faible impédance, cet étant de faible impédance du JFET se produisant lorsque le deuxième réseau de diodes n'est pas éclairé, le JFET fournissant une polarisation de fermeture au DMOS lorsque le JFET est à une forte impédance, cet état de forte impédance se produisant lorsque le deuxième réseau de diodes est éclairé.

6. Commutateur suivant l'une quelconque des revendications précédentes, dans lequel les réseaux de diodes (D—V, D—V₂) et l'émetteur de lumière (L-1) sont disposés dans le même plan, et dans lequel un film mince recouvre les réseaux de diodes et l'émetteur de lumière et constitue entre eux un chemin de couplage optique.

7. Commutateur suivant l'une quelconque des revendications 1 à 5, dans lequel toutes les diodes de chacun des réseaux de diodes (D—V, D—V₂) sont construites sur la même pastille par technologie d'isolation diélectrique, la pastille contenant également une île métallisée, électriquement isolée du réseau et de chaque FET, sur laquelle est placé l'émetteur de lumière (L-1), et la pastille étant revêtue d'un film de réfraction transparent mince, pour effectuer le couplage entre l'émetteur et les réseaux de diodes, de sorte qu'un commutateur analogique optiquement isolé est créé dans un petit espace.

8. Commutateur suivant la revendication 6 ou 7, dans lequel tous les éléments de ce commutateur sont fabriqués en arséniure de gallium sur une même pastille monolithique par utilisation d'isolation diélectrique.

9. Commutateur suivant l'une quelconque des revendications précédentes, dans lequel les diodes des réseau de diodes (D—V, D—V₂) sont disposées autour de l'émetteur de lumière (L-1) de manière à être également éclairées par celui-ci.

Fig. 1

Fig. 2

Fig. 3

1

Fig. 4

Fig. 5

Fig. 6

2

D-V₂

Q-2

D-V

L-1

Q-1

**Fig. 7**

16 DIODE PHOTOVOLTAIC ARRAY          LED          SUBSTRATE

**Fig. 8**

3

Fig. 9

Fig. 10

Fig. 11